(19) Europäisches Patentamt
European Patent Office
Office européen des brevets

(11) EP 1 172 670 A2

## (12) EUROPEAN PATENT APPLICATION

(43) Date of publication:
16.01.2002 Bulletin 2002/03

(51) Int Cl.⁷: G02B 1/10, G02B 13/14

(21) Application number: 01115800.3

(22) Date of filing: 11.07.2001

(84) Designated Contracting States:
AT BE CH CY DE DK ES FI FR GB GR IE IT LI LU
MC NL PT SE TR
Designated Extension States:
AL LT LV MK RO SI

(30) Priority: 11.07.2000 JP 2000209600

(71) Applicant: Nikon Corporation
Tokyo 100-8331 (JP)

(72) Inventor: Watanabe, Shunji, Nikon Corp.,
Intell. Prop. Dep.
Chiyoda-ku, Tokyo 100-8331 (JP)

(74) Representative: HOFFMANN - EITLE
Patent- und Rechtsanwälte Arabellastrasse 4
81925 München (DE)

(54) **Optical element formed with optical thin film and ultraviolet exposure apparatus**

(57) An optical element comprises an optical element body composed of fluoride, an $Al_2O_3$ layer formed thereon, and an $SiO_2$ layer formed on the $Al_2O_3$ layer. The $Al_2O_3$ layer is unreactive with fluorine of the fluoride. Therefore, even when the light in the deep ultraviolet region such as the light of 193 nm is used, no absorption loss of light is brought about. The optical element is usable for an optical lens of an illumination optical system or a projection lens in a projection optical system of an exposure apparatus which uses a light source of an excimer laser in order to effect exposure with a fine pattern.

**Fig. 7**

OPTICAL ELEMENT

EP 1 172 670 A2

## Description

## BACKGROUND OF THE INVENTION

Field of the Invention:

The present invention relates to an optical element which is composed of fluoride with an optical thin film formed on the surface. In particular, the present invention relates to an optical element which is effective, for example, to collect and reflect light having a wavelength in a deep ultraviolet region. The present invention also relates to an exposure apparatus provided with the optical element, and a method for producing the optical element.

Description of the Related Art:

Many optical thin films are applied to the optical system. For example, an anti-reflection film is applied onto the surface of the optical element such as a lens and a prism in order to reduce unfavorable reflection. A reflection film is applied onto the surface of the optical element in order to efficiently reflect incident light at the surface of the optical element so that the light is transmitted with desired optical characteristics without decreasing the amount of light.

In general, the optical thin film as described above is formed, for example, by means of vacuum deposition and sputtering. At present, the integration is highly advanced and the function is highly progressive for ULSI in the optical system of the exposure apparatus for semiconductors. A projection lens thereof is required to have a high resolution and a deep depth of focus in order to successfully obtain a processing line width of 0.18 $\mu$m. The resolution and the depth of focus are determined by the wavelength of light used for the exposure and N.A. (numerical aperture) of the lens.

The finer the pattern is, the larger the angle of the diffracted light is. Unless N.A. of the lens is large, it is impossible to pickup the diffracted light. On the other hand, the shorter the exposure wavelength $\lambda$ is, the smaller the angle of diffraction of the diffracted light from an identical pattern is. Therefore, it is enough to use small N.A. The resolution and the depth of focus are represented by the following expressions.

$$\text{Resolution} = k_1 \cdot \lambda / \text{N.A.}$$

$$\text{Depth of focus} = k_2 \cdot \lambda / (\text{N.A.})^2$$

(In the expressions, $k_1$I and $k_2$ are proportional constants.)

Therefore, in order to improve the resolution, either N.A. may be increased, or $\lambda$ may be shortened. However, as also clarified from the foregoing expressions, it is rather advantageous to shorten $\lambda$ in view of the depth. From such a viewpoint, the wavelength of the light source is progressively shortened, from the g-ray (wavelength: 436 nm) to the i-ray (wavelength: 365 nm) and further to the excimer laser beams such as KrF (wavelength: 248 nm) and ArF (wavelength: 193 nm).

However, it has been hitherto extremely difficult to obtain a high performance optical thin film for an incident light beam in the deep ultraviolet region (for example, at wavelength of 193 nm and wavelength of 248 nm), unlike those obtained for the visible region, because of the following reason. That is, many coating materials cannot be used as optical thin films due to the light loss caused by the absorption of light by the coating materials in this wavelength region. The coating material, which can be used in such a deep ultraviolet region, is extremely limited.

As for the method for forming the film, an optical thin film, which has a smooth and dense surface of the thin film, can be formed by means of the sputtering such as the high frequency sputtering and the ion beam sputtering as compared with the vacuum deposition. The optical thin film, which has the smooth and dense surface of the thin film, has a small surface area. Therefore, small amounts of water in the atmospheric air and organic matters adhere to the film surface. Accordingly, the optical characteristics are scarcely changed upon irradiation with light. That is, it is possible to obtain an optical thin film which has the durability over a long period and the stability. However, at present, an optical thin film composed of fluoride, which is produced by the sputtering, has no sufficient optical characteristics. The material for the thin film is limited to oxide. The material, which satisfies two conditions, i.e., the absorption is small at a wavelength of 193 nm and the long time durability and the stability are provided, includes only two materials, i.e., silicon oxide ($SiO_2$) and aluminum oxide ($Al_2O_3$). In addition to the two materials described above, three materials are usable at a wavelength of 248 nm, i.e., hafnium oxide ($HfO_2$), zirconium oxide ($ZrO_2$), and scandium oxide ($ScO_2$).

Materials, which are practically used as the material for the optical element such as lenses and prisms to be used in the deep ultraviolet region (especially at a wavelength of 193 nm), are principally based on fluoride including, for example, silicon oxide ($SiO_2$), calcium fluoride ($CaF_2$), magnesium fluoride ($MgF_2$), and barium fluoride ($BaF_2$). Especially, in the case of $SiO_2$, it is impossible to satisfy the request for the material for the optical element to be used for an optical system which undergoes a large intensity of incident light, and for portions to be used for an optical system which is required to have a high transmittance. The material is limited to fluoride such as $CaF_2$, $MgF_2$, and $BaF_2$.

Accordingly, when an optical element for the ArF (wavelength: 193 nm) excimer laser wavelength, especially an optical element having high durability is produced, an optical thin film, which comprises $Al_2O_3$ and $SiO_2$ formed thereon, can be formed by means of the sputtering such as the high frequency sputtering and the ion beam sputtering on a substrate (or an element) of fluoride such as $CaF_2$, $MgF_2$, and $BaF_2$.

However, it has been revealed that even when a layer composed of $SiO_2$ is formed as a film by means of the sputtering such as the high frequency sputtering and the ion beam sputtering on a substrate (or an element) of fluoride such as $CaF_2$, $MgF_2$, and $BaF_2$ as described above, the light loss is not sufficiently decreased in the wavelength region of the short wavelength such as 193 nm.

## SUMMARY OF THE INVENTION

A first object of the present invention is to solve the problems involved in the conventional technique described above and provide an optical element having an optical thin film for the excimer laser wavelength and a method for producing the same.

A second object of the present invention is to provide an exposure apparatus which uses the excimer laser as a light source.

According to a first aspect of the present invention, there is provided an optical element comprising an optical element body which is composed of fluoride; a first layer which is formed on the optical element body and which is composed of a material unreactive with fluorine of the fluoride; and a second layer which is formed on the first layer and which is composed of a material containing silicon.

According to the present inventors, it has been revealed that when an $SiO_2$ layer is formed on a substrate composed of fluoride, the light absorption at the boundary is increased. It is considered that this phenomenon occurs due to the following reason. Fluorine (F) contained in the substrate and silicon (Si) contained in the layer are reacted with each other by the aid of the large collision energy caused by the sputtering to generate gaseous $SiF_4$. Accordingly, fluorine in the substrate is detached, giving rise to the deficiency of fluorine on the substrate surface. That is, fluorine is deficient as compared with the stoichiometric composition on the surface (boundary) of the fluoride substrate contacting with the $SiO_2$ layer. As a result, the optical absorption edge wavelength is shifted toward the long wavelength side as compared with the ideal crystal. Therefore, the light absorption, which is brought about by an optical element in the deep ultraviolet region, is increased. The optical element of the present invention is provided with the first layer composed of the material unreactive with fluorine of the fluoride, the first layer being arranged between the optical element body and the second layer composed of the material containing silicon. Therefore, the reaction, in which fluorine is detached from the surface of the optical element body, does not occur. Accordingly, the optical element is provided, which has low loss even for the light of not more than 250 nm, especially the light of 193 nm of the vacuum ultraviolet light.

The first layer is preferably made of aluminum oxide, hafnium oxide, zirconium oxide, or scandium oxide, because such a compound is unreactive with fluorine of the fluoride, and such a compound brings about low loss with respect to the light of the vacuum ultraviolet light of not more than 250 nm. Aluminum oxide is preferred, because it brings about low loss with respect to the light in the deep ultraviolet region, especially the light having a wavelength of 193 nm. These materials are also unreactive with the material containing silicon of the second layer.

The material containing silicon for constructing the second layer may be silicon oxide, because this compound brings about low loss with respect to the light having a wavelength in the deep ultraviolet region. The fluoride may be calcium fluoride, magnesium fluoride, or barium fluoride. The first layer has a film thickness which is preferably not less than 5 nm, for example, 5 to 100 nm, in order to play a role as a buffering layer of the first layer and maintain a high transmittance.

According to a second aspect of the present invention, there is provided an exposure apparatus for exposing a substrate with an image of a pattern on a mask; the exposure apparatus comprising an illumination optical system which illuminates the mask with vacuum ultraviolet light; and a projection optical system which includes an optical element and which projects the image of the pattern on the mask onto the substrate; wherein the optical element comprises an optical element body which is composed of fluoride; a first layer which is formed on the optical element body and which is composed of a material unreactive with fluorine of the fluoride; and a second layer which is formed on the first layer and which is composed of a material containing silicon.

According to a third aspect of the present invention, there is provided an exposure apparatus for exposing a substrate with an image of a pattern on a mask; the exposure apparatus comprising an illumination optical system which includes an optical element and which illuminates the mask with vacuum ultraviolet light; and a projection optical system which projects the image of the pattern on the mask onto the substrate; wherein the optical element comprises an optical element body which is composed of fluoride; a first layer which is formed on the optical element body and which is composed of a material unreactive with fluorine of the fluoride; and a second layer which is formed on the first layer and which is composed of a material containing silicon.

In the exposure apparatus of the present invention, the optical element of the present invention is used as the optical element, including, for example, a projection lens and an optical lens used in the projection optical system or the illumination optical system. Therefore, the light loss, which is caused by the light absorption by the optical element, is decreased even when the vacuum ultraviolet light, especially the light of not more than 250 nm is used in order to enhance the resolution of the exposure pattern.

According to a fourth aspect of the present invention, there is provided a method for producing an optical element; comprising forming, on an optical element body composed of fluoride, a first layer composed of a material unreactive with fluorine of the fluoride; and forming, on the first layer, a second layer composed of a material containing silicon. The first layer and the second layer can be formed by means of sputtering, especially ion beam sputtering.

BRIEF DESCRIPTION OF THE DRAWINGS

Fig. 1 shows an arrangement of a film according to the present invention.
Fig. 2 shows loss of an optical element of the present invention.
Fig. 3 shows transmittance of the optical element of the present invention.
Fig. 4 shows transmittance depending on the presence or absence of a buffer film.
Fig. 5 shows loss brought about the optical lens including a substrate depending on the presence or absence of the buffer film.
Fig. 6 shows a basic structure of an exposure apparatus based on the use of the optical element according to the present invention.
Fig. 7 shows a flow chart illustrating an outline of a method for producing the optical element according to the present invention.

DESCRIPTION OF THE PREFERRED EMBODIMENTS

An illustrative embodiment of the method for forming an optical thin film to be formed on the optical element of the present invention will be explained below. However, the present invention is not limited to this embodiment.

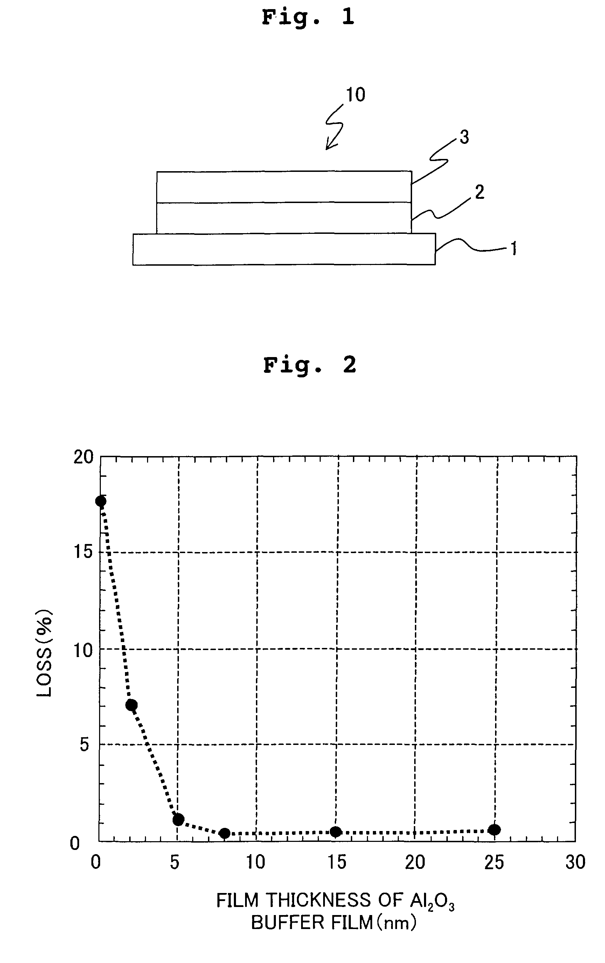

Fig. 1 shows a schematic structure of an optical element according to the present invention. As shown in Fig. 1, the optical element 10 includes a buffer film 2 formed on a substrate 1, and a silicon-containing film 3 formed thereon.

$CaF_2$, $MgF_2$, or $BaF_2$ is preferably used for the substrate 1. More preferably, $CaF_2$ is used, for the following reason. That is, these compounds have high transmittance with respect to the wavelength in the deep ultraviolet region.

Those preferably used for the buffer film 2 include aluminum oxide ($Al_2O_3$), hafnium oxide ($HfO_2$), zirconium oxide ($ZrO_2$), and scandium oxide ($ScO_3$). More preferably, $Al_2O_3$ is used. Any one of the substances described above may be used in a single layer-or in a multilayered structure superimposed with a plurality of layers for the buffer film 2. The film thickness of the buffer film 2 is preferably not less than 5 nm, in view of the fact that the buffer film 2 is used to avoid the reaction between silicon in the silicon-containing film 3 and fluorine in the fluoride of the optical element (substrate). For example, the film thickness may be 5 to 100 nm.

$SiO_2$ is preferred for the silicon-containing film 3. The film thickness of the silicon-containing film 3 is desirably 10 to 100 nm.

The method for forming the films of the buffer film 2 and the silicon-containing film 3 is preferably the ion beam sputtering. An ion beam sputtering apparatus comprises an ion source, a neutralizer which electrically neutralizes rare gas ion emitted from the ion source, and a target which serves as a raw material for the thin film material. The rare gas such as Ar (argon) and Xe (xenon) is introduced into the ion source to effect ionization so that the plus ion ($Ar^+$, $Xe^+$) is generated. The plus ion is attracted by a grid which is provided on the side of a vacuum chamber and which is applied with minus electricity. The plus ion is introduced into the vacuum chamber at a high velocity through a hole bored through the grid. The introduced plus ion is electrically neutralized by means of the neutralizer which generates electron or minus ion ($Ar^-$, $Xe^-$). Neutralized high velocity rare gas particles (Ar, Xe) collide with the target, and the target is subjected to the sputtering. A thin film is formed on the surface of the optical element which is fixed at the opposed position.

An example of the film formation condition is described below. The whole process of the film formation can be performed in the vacuum chamber in which the pressure is reduced to be not more than $10^{-6}$ Torr. Ar is used as the process gas for the ion source. For example, a filament is applied with a current and a voltage of 800 V and 40 mA to generate $Ar^+$ ion. Further, an acceleration voltage, for example, 45 kV is applied to the grid made of carbon. A target for the buffer film, for example, an $Al_2O_3$ target is directed so that Ar, which is neutralized by the neutralizer, is radiated toward the target. When an $SiO_2$ film is formed, Ar is radiated toward an $SiO_2$ target in the same manner as described above. $O_2$ is introduced, because the film substance is the oxide. The film is formed at $10^{-4}$ Torr, because the Ar process gas and the $O_2$ gas are introduced.

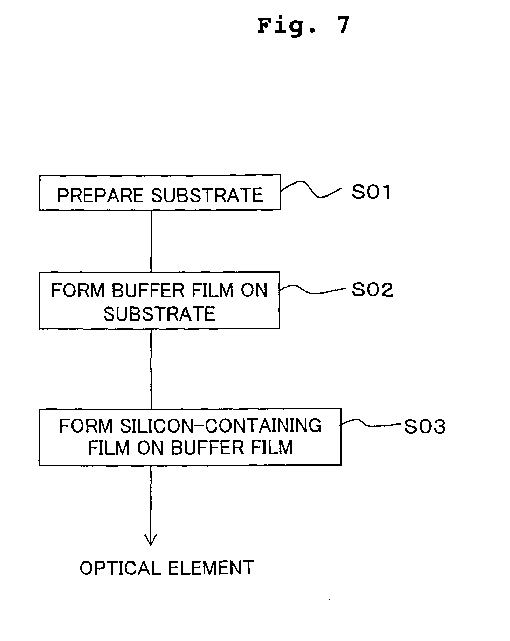

Fig. 7 shows the outline of the method for producing the optical element according to the present invention. In order to produce the optical element, a substrate such as a lens is prepared (step S01). A buffer film is formed thereon (step S02). An optical thin film is formed on the formed buffer film (step S03). Thus, the optical element is obtained.

Preparatory Experiment

In order to investigate the influence of the film thickness of the buffer film 3, the structure as shown in Fig. 1 was used to prepare a plurality of samples with various film thicknesses of $Al_2O_3$ films in each of which the buffer film 3 was the $Al_2O_3$ film 2. In each of the samples, the $SiO_2$ film 3 had a constant film thickness of 100 nm.

Fig. 2 shows the optical loss of the entire optical element including the substrate shown in Fig. 1. The optical loss is herein represented by (100 - transmittance - reflectance) %. The measuring wavelength is 193 nm. It is understood that when the film thickness of the $Al_2O_3$ buffer film is 0 nm, i.e., when the $SiO_2$ optical thin film is directly formed on the $CaF_2$ substrate, the large loss is exhibited, probably for the following reason. That is, fluorine (F) contained in the substrate and silicon (Si) contained in the optical thin film react with each other by the aid of the large collision energy caused by the sputtering to generate $SiF_4$. As a result, fluorine is deficient as compared with the stoichiometric composition at the boundary between the fluoride substrate and the $SiO_2$ thin film. As the thickness of the $Al_2O_3$ buffer film is increased, the loss is decreased. Sufficiently small loss is exhibited at a thickness of 8 nm. According to the results described above, when the $SiO_2$ optical thin film is formed on the $CaF_2$ substrate, it is possible to greatly decrease the loss with the extremely thin $Al_2O_3$ buffer film interposed therebetween.

Example 1

Next, an anti-reflection film of $Al_2O_3/SiO_2$ for a wavelength of 193 was specifically produced. An $Al_2O_3$ film was formed as the first layer (layer nearest to the substrate) with a film thickness of $\lambda/4$ on a $CaF_2$ substrate. In this case, $\lambda$ represents the designed central wavelength of 193 nm. The $Al_2O_3$ film serves as a high refractive index layer, and it also functions as a buffer film. An $SiO_2$ film was formed to have a film thickness of $\lambda/4$ as the second layer. The method for forming the film was the ion beam sputtering described above. The entire film formation process was performed in a vacuum chamber at a pressure reduced to be not more than $10^{-6}$ Torr. Ar was used as the process gas for the ion source, and the filament was applied with a current and a voltage of 800 V and 40 mA to generate $Ar^+$ ion. An acceleration voltage of 45 kV was applied to the grid made of carbon. Ar, which was neutralized by the neutralizer, was radiated onto the target, i.e., toward an $Al_2O_3$ target or an $SiO_2$ target. The film formation rate was 0.024 nm/s for $Al_2O_3$ and 0.036 nm/s for $SiO_2$. $O_2$ was introduced, because the film substance was oxide. The film formation was performed at $10^{-4}$ Torr, because the Ar process gas and the $O_2$ gas were introduced. The anti-reflection films of $Al_2O_3/SiO_2$ were formed on both surfaces of the $CaF_2$ substrate.

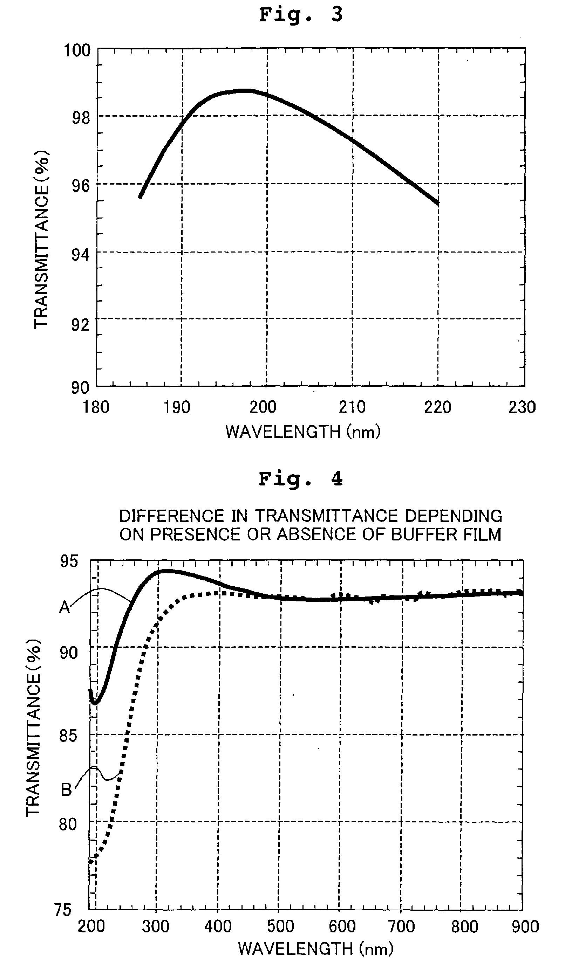

Fig. 3 shows the transmittance of the optical element formed with the film in accordance with the method described above. The horizontal axis indicates the measuring wavelength, and the vertical axis indicates the transmittance. As shown in Fig. 3, a good value, i.e., a transmittance of 98.6 % was exhibited at a wavelength of 193 nm.

Example 2 and Comparative Example

An $Al_2O_3$ buffer film was formed to have a thickness of 8 nm on a $CaF_2$ substrate having a thickness of 3 mm in accordance with the same method and the condition as those used in Example 1. An $SiO_2$ film was formed to have a thickness of 100 nm on the $Al_2O_3$ buffer film to produce an optical element A.

As Comparative Example, an $SiO_2$ film having a thickness of 100 nm was formed on a $CaF_2$ substrate having a thickness of 3 mm to produce an optical element B in the same manner as in Example 1 except that the $Al_2O_3$ buffer film was not formed.

Fig. 4 shows the change of the transmittance depending on the presence or absence of the buffer film. The horizontal axis indicates the wavelength, and the vertical axis indicates the transmittance. In the drawing, a solid line indicates the transmittance of the optical element A, and a dotted line indicates the transmittance of the optical element B. In Fig. 4, the wavelength, at which the transmittance of the optical element A exceeds the transmittance of the optical element B, ranges from the vicinity of a wavelength of 420 nm. The difference between the both is increased as the wavelength is shorter than the above.

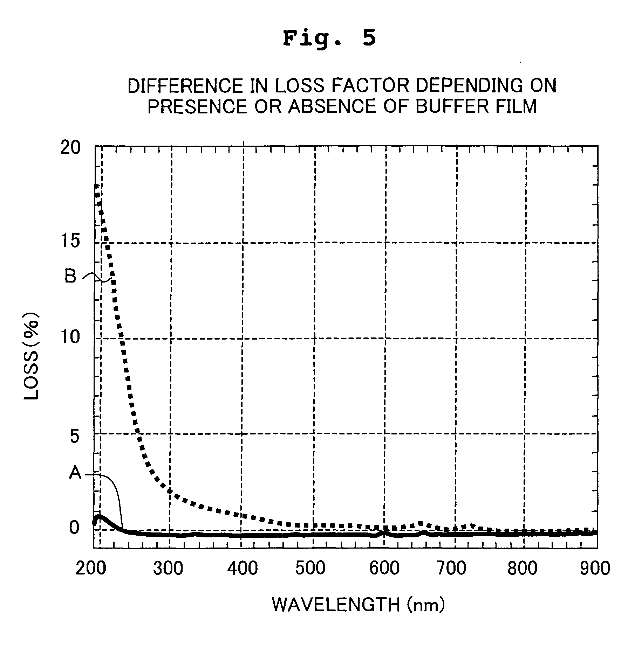

Fig. 5 shows the change of the loss of the optical element including the substrate depending on the presence or absence of the buffer film. The horizontal axis indicates the wavelength, and the vertical axis indicates the loss. In the drawing, a solid line indicates the loss of the optical element A, and a dotted line indicates the loss of the optical element B. In Fig. 5, the wavelength, at which the loss of the optical element A is superior to the loss of the optical element B, ranges from the vicinity of a wavelength of 780 nm. The difference between the both is increased as the wavelength is longer than the above. According to the results described above, it is understood that the optical element according to the present invention has more excellent optical characteristics than the conventional optical element.

Application to Exposure Apparatus

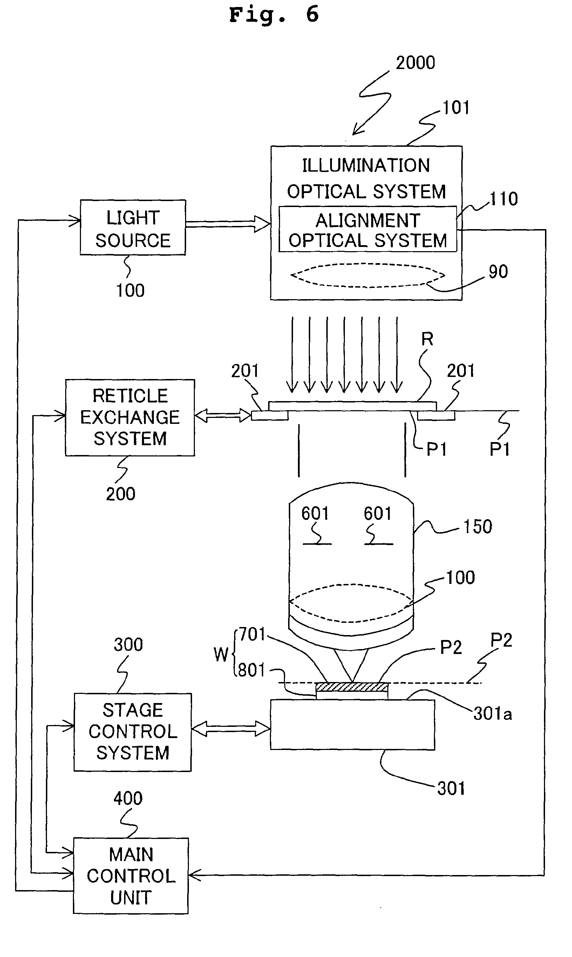

Next, an example of the exposure apparatus based on the use of the optical element of the present invention will be explained with reference to Fig. 6. Fig. 6 conceptually illustrates a scanning type projection exposure apparatus 2000 for exposing a wafer 801 (W as a whole) coated with photoresist 701 with an image of a pattern on a reticle R. The optical element produced in Example 1 or 2 can be applied to the exposure apparatus.

As shown in Fig. 6, the projection exposure apparatus of the present invention comprises at least a reticle stage 201 which is movable in a direction parallel to the surface of the reticle R while holding the reticle R (mask), a wafer stage 301 which is movable in a direction parallel to the wafer surface while holding the wafer (substrate) W on a surface 301a, an illumination optical system 101 which is provided to irradiate the reticle R (mask) with a vacuum ultraviolet light beam, a light source 100 which is provided to supply the vacuum ultraviolet light beam as the exposure light beam to the illumination optical system 101, and a projection optical system 150 which is provided to project the image of the pattern on the reticle R onto the wafer W. The projection optical system 150 is arranged between the reticle R and the wafer W so that the surface P1 on which the reticle R is arranged serves as the object plane, and the surface P2 of the wafer W serves as the image plane.

The illumination optical system 101 includes an alignment optical system 110 for performing relative positional adjustment for the reticle R and the wafer W. A reticle exchange system 200 exchanges and transports the reticle R set to the reticle stage 201. The reticle exchange system 200 includes a reticle stage driver (not shown) for moving the reticle stage 201. A stage control system 300 is provided with a wafer stage driver (not shown) for moving the wafer stage 301. A main control system 400 controls the reticle stage driver and the wafer stage driver by the aid of the stage control system 300 to drive the reticle stage and the wafer stage so that they are synchronously moved with respect to the exposure light beam. The projection optical system 150 further includes an alignment optical system 601 to be used for the scanning type exposure apparatus.

In the exposure apparatus 2000, it is possible to use the optical element produced in Examples described above. Specifically, the optical element produced in Example 1 or 2 can be used for the optical lens 90 of the illumination optical system 101 and the projection lens 100 of the projection optical system 150. Usually, a plurality of projection lenses 100 are arranged in the projection optical system 150. Especially, it is preferable that the lens, which is disposed on the light-outgoing side, i.e., at the position closest to the wafer W, is the lens according to the present invention. In this case, the optical thin film may be applied to only the light-incoming plane of the projection lens. Alternatively, the optical thin film may be applied to the entire lens. Further, the optical elements are used in the exposure apparatus, including, for example, the fly's eye lens, the various relay lenses, the beam splitter, the condenser lens, the beam expander, and the reflecting mirror. However, the present invention is applicable to any element.

Fig. 6 is illustrative of the scanning type projection exposure apparatus. However, the present invention is not limited thereto. The present invention is also applicable to the projection exposure apparatus based on the step-and-repeat system (so-called stepper), the mirror projection aligner, and the proximity type exposure apparatus. The optical element equipped with the reflection film can be applied, for example, to a reflecting plate to be used for the exposure apparatus having the projection optical system based on the reflecting system or the cata-dioptric system. The projection exposure apparatus and the optical elements used therefor are disclosed in United States Patent No. 5,835,275. This patent document is incorporated herein by reference.

Further, the optical element of the present invention is usable for various apparatuses other than the exposure apparatus, including, for example, spectroscopes, laser repair apparatuses, various inspection apparatuses, and sensors.

As explained above, according to the present invention, it is possible to obtain the optical element having the high optical characteristics even in the deep ultraviolet region by providing the buffer film having the low reactivity with the substrate between the substrate and the optical thin film. The exposure apparatus of the present invention uses the optical element which has the high transmittance and the low loss. Therefore, it is possible to decrease the loss of illuminance of the exposure light beam until arrival at the substrate as compared with the conventional exposure apparatus.

**Claims**

1.    An optical element (10) having an optical element body (1) which is composed of fluoride, **characterized by** comprising:;

    a first layer (2) which is formed on the optical element body and which is composed of a material unreactive with fluorine of the fluoride; and
    a second layer (3) which is formed on the first layer and which is composed of a material containing silicon.

2.    The optical element according to claim 1, wherein the first layer is at least one selected from a group consisting of aluminum oxide, hafnium oxide, zirconium oxide, and scandium oxide.

3.    The optical element according to claim 1, wherein the material containing silicon is silicon oxide.

4.    The optical element according to claim 1, wherein the fluoride is at least one selected from a group consisting of calcium fluoride, magnesium fluoride, and barium fluoride.

5.    The optical element according to any one of claims 1 - 4, wherein a film thickness of the first layer is not less than 5 nm.

6.    The optical element according to claim 1, wherein the first layer is composed of aluminum oxide, and the second layer is composed of silicon oxide.

7. An exposure apparatus (2000), for exposing a substrate with an image of a pattern on a mask, which comprises an illumination optical system (101) which illuminates the mask with vacuum ultraviolet light and a projection optical system (150) which includes an optical element (100) and which projects the image of the pattern on the mask onto the substrate, **characterized in that**:

the optical element (100) comprises an optical element body (1) which is composed of fluoride; a first layer (2) which is formed on the optical element body and which is composed of a material unreactive with fluorine of the fluoride; and a second layer (3) which is formed on the first layer and which is composed of a material containing silicon.

8. The exposure apparatus according to claim 7, wherein the first layer of the optical element is formed of aluminum oxide, and the second layer is composed of silicon oxide.

9. The exposure apparatus according to claim 7 or 8, wherein the vacuum ultraviolet light has a wavelength of not

10. An exposure apparatus, for exposing a substrate with an image of a pattern on a mask, which comprises an illumination optical system (101) which includes an optical element (90) and which illuminates the mask with vacuum ultraviolet light and a projection optical system which projects the image of the pattern on the mask onto the substrate, **characterized in that**:

the optical element (90) comprises an optical element body (1) which is composed of fluoride; a first layer (2) which is formed on the optical element body and which is composed of a material unreactive with fluorine of the fluoride; and a second layer (3) which is formed on the first layer and which is composed of a material containing silicon.

11. The exposure apparatus according to claim 10, wherein the first layer of the optical element is formed of aluminum oxide, and the second layer is composed of silicon oxide.

12. The exposure apparatus according to claim 10 or 11, wherein the vacuum ultraviolet light has a wavelength of not more than 250 nm.

13. A method for producing an optical element (10), comprising:

forming, on an optical element body (1) composed of fluoride, a first layer (2) composed of a material unreactive with fluorine of the fluoride; and forming, on the first layer, a second layer (3) composed of a material containing silicon.

14. The method for producing the optical element according to claim 13, wherein at least one of the first layer and the second layer is formed by means of sputtering.

15. The method for producing the optical element according to claim 13, wherein the first layer is at least one selected from a group consisting of aluminum oxide, hafnium oxide, zirconium oxide, and scandium oxide.

16. The method for producing the optical element according to claim 14, wherein the material containing silicon is silicon oxide.

17. The method for producing the optical element according to any one of claims 13 - 16, wherein the fluoride is at least one selected from a group consisting of calcium fluoride, magnesium fluoride, and barium fluoride.

18. The method for producing the optical element according to claim 13, wherein the first layer is formed with a film thickness of not less than 5 nm.

## Fig. 1

## Fig. 2

FILM THICKNESS OF $Al_2O_3$
BUFFER FILM (nm)

# Fig. 3

# Fig. 4

## DIFFERENCE IN TRANSMITTANCE DEPENDING ON PRESENCE OR ABSENCE OF BUFFER FILM

# Fig. 5

DIFFERENCE IN LOSS FACTOR DEPENDING ON
PRESENCE OR ABSENCE OF BUFFER FILM

# Fig. 6

2000

101

ILLUMINATION
OPTICAL SYSTEM

110

ALIGNMENT
OPTICAL SYSTEM

LIGHT
SOURCE

100

90

R

201          201

RETICLE
EXCHANGE
SYSTEM

200

P1          P1

601    601                150

100

300

STAGE
CONTROL
SYSTEM

W { 701
    801

P2      P2

301a

301

400

MAIN
CONTROL
UNIT

**Fig. 7**

```
┌─────────────────────────┐
│    PREPARE SUBSTRATE     │ ～～ SO1
└─────────────────────────┘
            │
┌─────────────────────────┐
│   FORM BUFFER FILM ON    │ ～～ SO2
│       SUBSTRATE          │
└─────────────────────────┘
            │
┌─────────────────────────┐
│  FORM SILICON-CONTAINING │ ～～ SO3
│   FILM ON BUFFER FILM    │
└─────────────────────────┘
            │
            ▼

      OPTICAL ELEMENT
```